(19) **Europäisches Patentamt / European Patent Office / Office européen des brevets**

(11) **EP 3 753 118 B1**

(12) **FASCICULE DE BREVET EUROPEEN**

(45) Date de publication et mention de la délivrance du brevet:
**15.06.2022 Bulletin 2022/24**

(21) Numéro de dépôt: **19700624.0**

(22) Date de dépôt: **18.01.2019**

(51) Classification Internationale des Brevets (IPC):
**H04B 3/54** *(2006.01)*    **G01R 29/18** *(2006.01)*
**H02J 3/00** *(2006.01)*    **H02J 13/00** *(2006.01)*
**G01R 19/25** *(2006.01)*

(52) Classification Coopérative des Brevets (CPC):
**H04B 3/54; G01R 29/18; H02J 3/00;**
**H02J 13/00002; H02J 13/00007; H02J 13/00032;**
G01R 19/2513; H02J 2203/20; H04B 2203/5466;
Y02B 90/20; Y02E 60/00; Y02E 60/7815;
Y04S 10/30; Y04S 40/121

(86) Numéro de dépôt international:
**PCT/EP2019/051293**

(87) Numéro de publication internationale:
**WO 2019/158312 (22.08.2019 Gazette 2019/34)**

(54) **DETERMINATION DE LA PHASE D'UN CONDUCTEUR APPARTENANT A UN RESEAU POLYPHASE**

BESTIMMUNG DER PHASE EINES ZU EINEM MEHRPHASIGEN NETZWERK GEHÖRENDEN LEITERS

DETERMINATION OF THE PHASE OF A CONDUCTOR PERTAINING TO A POLYPHASE NETWORK

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **16.02.2018 FR 1851354**

(43) Date de publication de la demande:
**23.12.2020 Bulletin 2020/52**

(73) Titulaires:
• **Enedis**
**92079 Paris La Defense Cedex (FR)**
• **Fameca Electronics**
**68170 Rixheim (FR)**

(72) Inventeurs:
• **LAVENU, Cédric**
**91300 MASSY (FR)**
• **CAQUEUX, Mickaël**
**68530 BUHL (FR)**
• **BRETAND, David**
**68720 TAGOLSHEIM (FR)**

(74) Mandataire: **Plasseraud IP**
**66, rue de la Chaussée d'Antin**
**75440 Paris Cedex 09 (FR)**

(56) Documents cités:
**WO-A1-2005/116668**    **US-A1- 2015 091 545**

## Description

La présente invention concerne la détermination de la phase d'un conducteur électrique qui appartient à un réseau polyphasé de distribution de courant électrique.

Dans un réseau polyphasé de distribution de courant électrique, notamment un réseau triphasé, il est utile de connaître la phase d'un conducteur électrique de ce réseau, lorsque c'est un conducteur de phase, notamment pour équilibrer entre les différentes phases du réseau la puissance électrique qui est fournie par le réseau.

Des méthodes existent pour comparer entre elles les phases de plusieurs conducteurs du réseau, notamment à l'aide d'appareils portatifs qui déterminent l'ordre des phases des conducteurs qui sont testés. Mais ces méthodes requièrent l'installation de deux appareils pour déterminer les phases des conducteurs à un endroit du réseau par rapport à une phase de référence qui est définie à un autre endroit du réseau, éloigné de l'endroit où les phases sont testées. En effet, un premier appareil portatif doit être installé pour cela à l'endroit du réseau où les phases sont testées, alors qu'un second appareil portatif est installé à l'autre endroit du réseau sur le conducteur qui détermine la phase de référence.

Par ailleurs, les technologies CPL, pour «courant porteur en ligne», conformément aux normes correspondantes, permettent de transmettre des données en utilisant comme support de transmission les conducteurs de distribution du courant électrique. Pour cela, des unités de production de données à transmettre, et aussi auxquelles des données peuvent être destinées, sont connectées à divers endroits du réseau de distribution de courant électrique par l'intermédiaire de modems dédiés. De telles unités peuvent être notamment des compteurs de consommation électrique, qui sont alors dits compteurs communicants, tels que les compteurs Linky® actuellement déployés par ENEDIS®.

La norme CPL G3 permet des communications par transmission de trames qui sont dites asynchrones. En effet, dans le protocole CPL G3, les trames sont émises à des instants qui correspondent à des valeurs variables de la phase instantanée de la tension électrique du conducteur du réseau à partir duquel la trame est émise. Mais la norme CPL G3 prévoit que les trames de type balise, ou «beacon» en anglais, contiennent chacune une indication de la valeur instantanée de la phase de la tension électrique du conducteur à partir duquel la trame est émise, telle que cette valeur instantanée de phase existe à l'instant auquel cette trame est émise. Une durée de traitement de la trame à l'émission peut être négligée, ou peut être prise en compte dans une correction qui sera appliquée lors de la réception de la trame. Cette indication de valeur instantanée de la phase de la tension électrique est produite par le modem émetteur de la trame au moyen d'un compteur de phase à 8 bits, qui est incrémenté à la fréquence du réseau multipliée par 256. Ainsi, un cycle de comptage est parcouru pendant chaque période de la tension électrique, et un nouveau passage du compteur de phase par la valeur nulle est effectué chaque fois que la tension électrique du conducteur passe par zéro sur un front montant. Selon la norme CPL G3, la valeur de ce compteur de phase à l'instant d'émission d'une trame de balise est systématiquement inscrite sans cryptage dans le champ PDC de l'en-tête de cette trame. Elle est donc lisible pour un récepteur qui est muni d'un modem CPL G3 sans qu'une procédure d'authentification de ce récepteur soit nécessaire, et sans qu'une clé de décryptage soit nécessaire.

Par ailleurs, la norme CPL G3 prévoit qu'un modem qui est raccordé au réseau puisse émettre une requête d'émission de balise, aussi désignée par requête de balise. D'autres modems, qui sont aussi connectés au réseau et qui reçoivent cette requête de balise, y répondent en émettant chacun une trame de balise sur le réseau. Le modem émetteur de la requête collecte alors les trames de balises, et enregistre pour chacune d'elles une adresse du modem émetteur de cette trame de balise, et l'indication de valeur instantanée de phase qui est contenue dans le champ PDC de la trame de balise. Il compare alors cette indication de valeur instantanée de phase qui est lue, et qui concerne le conducteur auquel est connecté le modem émetteur de la trame de balise, avec la valeur instantanée de son propre compteur de phase. A partir d'une différence entre la valeur de phase qui est lue dans la trame de balise et celle qui est fournie par son propre compteur de phase, le modem récepteur de la trame de balise obtient la valeur du déphasage qui existe entre la tension électrique du conducteur du modem émetteur de la trame de balise et celle du conducteur auquel il - le modem récepteur de la trame de balise qui est aussi l'émetteur de la requête de balise - est lui-même connecté. La durée de propagation de la trame de balise dans le réseau entre les deux modems est négligeable. Eventuellement, le déphasage qui est ainsi calculé peut être corrigé d'une durée de traitement de la trame de balise dans les deux modems. Les modems qui ont répondu à la requête de balise sont ceux qui, dans le réseau, ne sont pas trop éloignés du modem émetteur de cette requête pour avoir reçu cette dernière dans des conditions satisfaisantes, et qu'ensuite la trame de balise qui est émise par chacun d'eux soit reçue aussi dans des conditions satisfaisantes par le modem émetteur de la requête. Les modems qui ont participé à un tel échange de communication sont usuellement appelés «voisins» du modem émetteur de la requête. Ce dernier mémorise alors une table, dite «table des voisins», dans laquelle l'adresse de chaque modem voisin est associée à la valeur du déphasage qui existe entre les conducteurs respectifs du réseau auxquels sont connectés ce modem voisin et le modem qui héberge la table.

Toutefois, la norme CPL G3 ne prévoit pas d'identifier la phase d'un conducteur du réseau par rapport à une phase de référence qui serait commune à tout le réseau, ou commune à au moins une partie du réseau comprenant plusieurs modems qui ne sont pas tous voisins entre eux. Autrement dit, les tables de voisins qui sont mémorisées dans chaque modem utilisent chacune comme référence de phase la phase du conducteur du réseau auquel ce modem est connecté, et non pas une phase de référence commune.

Le document WO 2005/116668 A1 décrit une méthode pour déterminer la phase relative d'un conducteur quelconque d'un réseau multiphasé. Selon cette méthode, l'information qui est récupérée est une indication d'un nombre de décalage de phase décompté entre l'émission d'un message d'interrogation et sa réception, éventuellement avec des relais de transmission intermédiaires.

Le document US 2015/091545 A1 concerne aussi la détermination de phases de conducteurs d'un réseau multiphasé, mais il décrit une méthode qui est basée sur la détection des instants d'annulation de la tension des conducteurs.

La présente invention a alors pour but de déterminer la phase d'un conducteur de phase d'un réseau polyphasé, par rapport à une phase de référence qui est commune à tout le réseau, ou à une grande partie de celui-ci.

En outre, un but complémentaire de l'invention est de pouvoir déterminer la phase d'un conducteur de phase quelconque du réseau, même lorsque le réseau ne comporte pas de modem qui soit connecté à ce conducteur de phase, et aussi lorsque des trames CPL ne peuvent pas être transmises directement entre ce conducteur de phase et un autre qui détermine la phase de référence.

En particulier, l'invention a pour but de déterminer la phase d'un conducteur de phase lorsque le réseau est équipé pour un mode de communication de type CPL asynchrone.

Enfin, un but annexe de l'invention est de déterminer la phase d'un conducteur du réseau en ne nécessitant que des interventions de la part d'un seul opérateur qui soient simples et courtes à réaliser. Notamment, si l'invention met en œuvre un appareil de communication CPL qui est externe au réseau, il est recherché que la communication entre cet appareil et les modems du réseau ne nécessite pas d'exécuter une procédure d'association de l'appareil avec le réseau, ni de procédure d'authentification.

Pour atteindre l'un au moins de ces buts ou d'autres, un premier aspect de l'invention propose un nouveau procédé pour déterminer la phase d'un conducteur de phase qui appartient à un réseau polyphasé de distribution de courant électrique, notamment un réseau triphasé. Dans ce cadre, un conducteur de phase quelconque du réseau possède une phase qui détermine un déphasage de tension électrique existant entre ce conducteur et un autre conducteur de phase du réseau servant de référence, appelé conducteur de phase de référence.

Pour l'invention, le réseau comporte des modems qui sont connectés chacun à un des conducteurs de phase du réseau, et qui sont adaptés pour communiquer selon un protocole de courant porteur en ligne, ou CPL. Autrement dit, le réseau auquel l'invention est appliquée est du type réseau communicant de distribution de courant électrique.

Le procédé de l'invention comprend alors les étapes suivantes :

/1/ connecter à un des conducteurs de phase du réseau, dit conducteur de mesure, dont la phase est à déterminer, un appareil portatif qui comprend un modem externe au réseau mais conforme au protocole de courant porteur en ligne de ce réseau ;

/2/ à l'aide de l'appareil portatif qui est connecté au conducteur de mesure, injecter une requête dans le réseau à partir du conducteur de mesure, pour déclencher une émission en réponse à cette requête, de la part d'au moins un des modems du réseau, d'une trame qui contient une indication d'une valeur de phase instantanée de la tension électrique du conducteur auquel est connecté le modem émetteur de cette trame, cette valeur instantanée de phase de la tension électrique du conducteur auquel est connecté le modem émetteur de la trame existant à l'émission de celle-ci ;

/3/ à l'aide de l'appareil portatif qui est encore connecté au conducteur de mesure, collecter la trame qui a été émise par l'un au moins des modems du réseau en réponse à la requête, et lire l'indication de valeur instantanée de phase qui est contenue dans cette trame ; et

/4/ pour chaque trame reçue en réponse à la requête, déduire de l'indication de valeur instantanée de phase qui a été lue dans cette trame, par soustraction d'une indication de la valeur instantanée de phase de la tension électrique du conducteur de mesure, telle qu'existant à un instant de réception de la trame par l'appareil portatif, une valeur d'un déphasage qui existe entre le conducteur auquel est connecté le modem émetteur de la trame et le conducteur de mesure.

La valeur de déphasage qui est déduite à l'étape /4/ indique alors la phase du conducteur de mesure lorsque le conducteur du modem émetteur de la trame est le conducteur de phase de référence. Dans ce cas, le conducteur de chaque modem émetteur d'une trame qui est collectée à l'étape /3/ peut être qualifié de rang 1, puisque la même requête a atteint ce conducteur et aussi le conducteur de phase de référence.

L'appareil portatif qui est utilisé dans un tel procédé peut n'utiliser que des champs de requêtes et de trames de réponse à ces requêtes dont les contenus ne sont pas cryptés. Grace à cela, la communication de l'appareil portatif avec des modems du réseau ne nécessite pas que l'appareil soit associé au réseau, ni qu'aucune procédure d'authentification soit utilisée. En particulier pour cette raison, le procédé de l'invention ne nécessite qu'un raccordement pendant quelques secondes de l'appareil portatif au réseau. L'appareil portatif peut alors être connecté au réseau en n'utilisant que des moyens de contact électrique temporaire, tels que des pointes de touche. L'appareil portatif peut ainsi être de petites dimensions et léger, si bien qu'il peut faire partie de l'équipement individuel d'un opérateur itinérant le long réseau.

Lorsque plusieurs trames sont collectées à l'étape /3/, qui ont été émises par au moins deux des modems du réseau en réponse à la requête, le procédé peut comprendre l'étape supplémentaire suivante :

/5/ soustraire l'une à l'autre les valeurs de déphasage déduites à l'étape /4/ pour les deux conducteurs du réseau auxquels sont connectés les deux modems qui ont émis les trames, afin d'obtenir une valeur de déphasage de ces deux conducteurs du réseau l'un par rapport à l'autre.

Ainsi, le conducteur de mesure sert de relais entre les conducteurs des deux modems qui ont émis des trames, pour déterminer le déphasage qui existe entre les tensions électriques respectives de ces deux derniers conducteurs.

Dans ce cas, la valeur de déphasage qui est obtenue à l'étape /5/ indique la phase d'un des conducteurs du réseau auquel est connecté l'un des deux modems qui ont émis les trames, lorsque le conducteur auquel est connecté l'autre des deux modems qui ont émis les trames est le conducteur de phase de référence.

Dans une première extension du procédé de l'invention, les étapes /1/ à /5/ peuvent être exécutées une première fois en connectant d'abord l'appareil portatif à un premier conducteur de mesure appartenant au réseau, pour obtenir lors d'une première exécution de l'étape /5/, dite étape /5-1/, une valeur de déphasage qui existe entre un premier conducteur de phase du réseau et un deuxième conducteur de phase du réseau. Pour cela, les ainsi-nommés premier et deuxième conducteurs de phase sont différents du premier conducteur de mesure. Puis les étapes /1/ à /5/ sont exécutées une seconde fois en connectant l'appareil portatif à un second conducteur de mesure appartenant au réseau, qui est différent du premier conducteur de mesure, pour obtenir lors d'une seconde exécution de l'étape /5/, dite étape /5-2/, une autre valeur de déphasage qui existe entre le deuxième conducteur de phase du réseau et un troisième conducteur de phase du réseau. Pour cela de même, les ainsi-nommés deuxième et troisième conducteurs de phase sont différents du second conducteur de mesure. Alors, lors d'une étape /6/ supplémentaire du procédé, les valeurs de déphasage qui ont été obtenues aux étapes /5-1/ et /5-2/ sont combinées l'une avec l'autre, pour obtenir la valeur de déphasage qui existe entre les premier et troisième conducteurs de phase du réseau. Et lorsque le premier conducteur de phase est le conducteur de phase de référence, la valeur de déphasage qui est obtenue à l'étape /6/ indique la phase du troisième conducteur de phase. Dans ce cas, le troisième conducteur de phase est dit de rang 2, puisque sa phase est accessible en combinant deux mesures, respectivement en connectant l'appareil portatif au premier conducteur de mesure, puis au second.

Le procédé de l'invention peut ensuite être poursuivi itérativement, par des extensions supplémentaires de ce procédé, afin de déterminer la phase de conducteurs du réseau de rangs supérieurs. Ainsi, la valeur de déphasage qui a été obtenue à l'étape /6/ entre les premier et troisième conducteurs de phase du réseau, peut être combinée lors d'une étape /7/ avec une valeur de déphasage qui existe entre le troisième conducteur de phase du réseau et un quatrième conducteur de phase du réseau, pour obtenir une valeur de déphasage qui existe entre les premier et quatrième conducteurs de phase du réseau. De nouveau, lorsque le premier conducteur de phase est le conducteur de phase de référence, la valeur de déphasage qui est obtenue à l'étape /7/ indique la phase du quatrième conducteur de phase. En particulier, la valeur du déphasage entre les troisième et quatrième conducteurs de phase du réseau peut avoir été obtenue selon l'invention, de la même façon que la valeur du déphasage entre les deuxième et troisième conducteurs de phase du réseau.

Dans diverses mises en œuvre de l'invention, les caractéristiques optionnelles suivantes peuvent en outre être utilisées, indépendamment les unes des autres ou en combinaison de plusieurs d'entre elles :

- à l'étape /3/, l'indication de la valeur instantanée de phase qui est lue dans la trame, peut être mémorisée dans l'appareil portatif ou dans une unité de mémorisation qui est connectée à une sortie de l'appareil portatif, en liaison avec une adresse du modem émetteur de cette trame, et en liaison avec l'indication de la valeur instantanée de phase de la tension électrique du conducteur de mesure, telle qu'existant à l'instant de réception de la trame concernée par l'appareil portatif, et éventuellement en liaison aussi avec une adresse et/ou un identifiant du conducteur de mesure ;

- un des modems émetteur d'une trame qui a été collectée lors d'une exécution de l'étape /3/, peut être une partie d'un concentrateur du réseau. Dans ce cas, le conducteur de phase du réseau auquel est connecté le concentrateur peut être le conducteur de phase de référence ;

- le protocole de courant porteur en ligne qui est utilisé dans le réseau de distribution de courant électrique peut être le protocole CPL G3 ;

- la requête qui est injectée dans le réseau par l'appareil portatif à l'étape /2/ peut être une requête de balise. Dans ce cas, chaque trame qui est collectée à l'étape /3/ est une trame de balise qui contient l'indication de la valeur instantanée de phase de la tension électrique du conducteur auquel est connecté le modem émetteur de cette trame de balise, telle que cette valeur instantanée de phase existe à l'émission de la trame de balise ;

- l'appareil portatif peut comprendre deux connecteurs dont chacun est adapté pour établir un contact électrique avec un conducteur du réseau. Alors, l'appareil portatif est connecté à chaque exécution de l'étape /1/ entre le conducteur de mesure concerné d'une part, et un conducteur de neutre ou de terre du réseau d'autre part ; et

- les phases qui sont déterminées par le procédé de l'invention pour plusieurs conducteurs du réseau, lorsqu'elles sont différentes, peuvent être utilisées pour équilibrer entre ces conducteurs une puissance électrique qui est fournie par le réseau.

En outre, un second aspect de l'invention propose un appareil portatif qui est adapté pour exécuter au moins les étapes /1/ à /4/ d'un procédé conforme au premier aspect de l'invention, et qui comprend :

- deux connecteurs, dont l'un est adapté pour établir un contact électrique avec un conducteur de phase d'un réseau polyphasé de distribution de courant électrique, et l'autre est adapté pour établir un autre contact électrique avec un conducteur de neutre ou un conducteur de terre du même réseau ;

- un modem, qui est raccordé aux deux connecteurs et adapté pour communiquer selon un protocole de courant porteur en ligne, ou CPL ;

- un contrôleur, qui est agencé pour commander au modem d'émettre une requête de trame par les deux connecteurs ; et

- une sortie, qui est agencée pour transmettre l'une au moins des valeurs suivantes :

    une valeur de déphasage qui existe entre deux conducteurs de phase du réseau, calculée par l'appareil portatif,

    une indication d'une valeur instantanée de phase qui est lue dans une trame reçue par le modem par l'intermédiaire des deux connecteurs, et

    une indication d'une autre valeur instantanée de phase, qui est fournie par le modem de l'appareil portatif lorsqu'une trame est reçue par celui-ci, et qui est relative à une tension électrique d'un conducteur de phase du réseau avec lequel l'un des deux connecteurs de l'appareil portatif est en contact électrique.

D'autres particularités et avantages de la présente invention apparaîtront dans la description ci-après d'un exemple de réalisation non limitatif, en référence au dessin suivant qui est annexé :

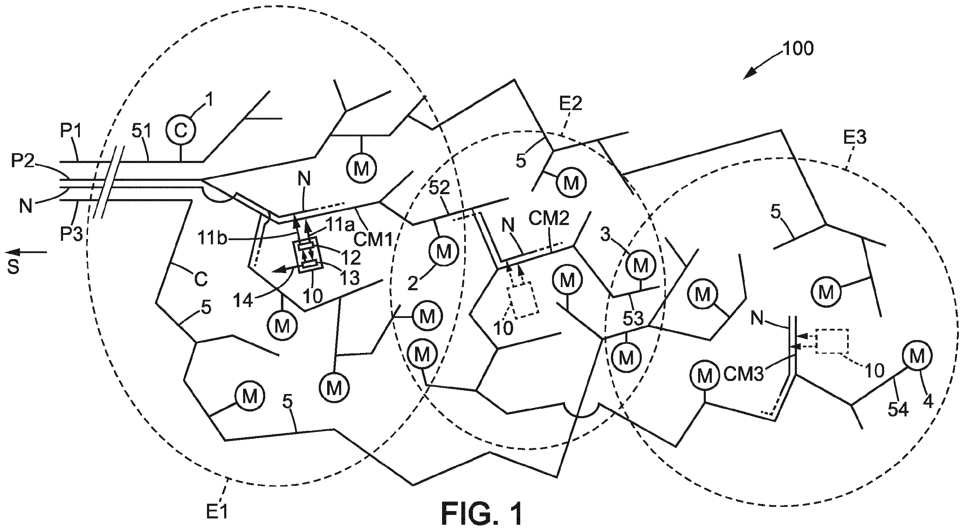

- la figure 1 représente un réseau de distribution de courant électrique auquel l'invention est appliquée.

Pour raison de clarté, les dimensions des éléments qui sont représentés dans cette figure ne correspondent ni à des dimensions réelles ni à des rapports de dimensions réels. En outre, des références identiques qui y sont indiquées désignent des éléments identiques ou qui ont des fonctions identiques.
Un réseau de distribution de courant électrique 100 est par exemple un réseau triphasé. A ce titre, il comprend des conducteurs 5 qui ont chacun l'une des trois phases du réseau, et qui sont appelés conducteurs de phase. Les trois phases du réseau 100 peuvent être désignées par 0°, 120° et 240°. Par exemple, trois conducteurs du réseau, en provenance d'une source S de production de courant électrique, peuvent avoir la phase 0° pour l'un qui est référencé P1, la phase 120° pour un deuxième d'entre eux qui est référencé P2, et la phase 240° pour le troisième qui est référencé P3. Tous les conducteurs 5 du réseau 100 qui sont raccordés au conducteur P1 ont alors la phase 0°, tous ceux qui sont raccordés au conducteur P2 ont la phase 120°, et tous ceux qui sont raccordés au conducteur P3 ont la phase 240°. Le problème technique que résout l'invention est de déterminer laquelle de ces trois phases, 0°, 120° et 240°, est celle d'un conducteur 5 quelconque du réseau 100, lorsqu'il n'est pas possible de suivre physiquement la suite des raccordements qui relient ce conducteur 5 à l'un des trois conducteurs P1, P2 et P3.
Evidemment, le réseau 100 est pourvu de conducteurs de neutre N, ainsi appelés dans le jargon du l'Homme du métier, qui sont disposés chacun en parallèle d'un conducteur de phase 5. Tous les conducteurs de neutre N sont raccordés à un même conducteur de neutre qui provient de la source S de production du courant électrique.
Une telle architecture de réseau triphasé de distribution de courant électrique est bien connue, de sorte qu'il n'est pas nécessaire de la décrire plus en détail ici.
Le réseau 100 est dit communiquant lorsque des unités de communication par CPL sont connectées à certains des conducteurs 5. D'une façon qui est encore connue, chacune de ces unités de communication est munie d'un modem, qui constitue l'interface entre un module informatique de cette unité de communication et le réseau 100. Les modems convertissent des données numériques à transmettre, fournies à chacun par le module informatique correspondant, en signaux analogiques qui sont transportés par les conducteurs 5, en superposition au courant électrique qui est délivré à des points de consommation de puissance électrique. Inversement, chaque modem restitue des données numériques qui sont contenues dans des signaux analogiques reçus, et les transmet au module informatique.

Les unités de communication par CPL peuvent être des compteurs de consommation électrique qui sont disposés à certains au moins des points de consommation de puissance électrique desservis par le réseau 100. Dans la figure 1, de tels compteurs de consommation électrique sont désignés par des lettres M qui sont reliées chacune à un des conducteurs de phase 5, pour indiquer le mode de connexion de ce compteur de consommation électrique au réseau 100 à travers son modem. Une connexion complémentaire de chaque compteur de consommation électrique M à un conducteur de neutre N du réseau 100 n'est pas représentée, étant évidente pour l'Homme du métier.

La lettre C, aussi repérée par la référence 1, indique un concentrateur qui est connecté au réseau 100. De façon connue, un tel concentrateur permet d'interroger les compteurs de consommation électrique M, de traiter et stocker les données et informations qu'il reçoit, et de les transmettre à un système d'information centralisé (non représenté). Lui-même en tant qu'unité de communication, le concentrateur C contient aussi un modem, qui est connecté à un des conducteurs de phase du réseau 100, indiqué par la référence 51. Evidemment, il est simultanément connecté à un conducteur de neutre. Pour la suite, on considère que la connexion de ce concentrateur C au réseau 100 définit celle des phases qui est prise pour référence, et qui est notée 0°. Autrement dit, le conducteur de phase 51 est le conducteur de phase de référence. Les phases 120° et 240° sont alors fixées par l'ordre chronologique de passage par la valeur nulle sur un front montant, de la tension électrique des conducteurs de phase correspondants. En fait, le concentrateur C peut être aussi connecté simultanément à des conducteurs des phases 120° et 240°, notamment par des condensateurs, pour améliorer une qualité de transmission des signaux CPL. Mais ces deux connexions supplémentaires du concentrateur C n'interviennent pas dans l'identification de la phase de référence, et peuvent être ignorées dans la suite.

On suppose pour la suite que le protocole de communication par courant porteur en ligne qui est mis en œuvre dans le réseau 100 satisfait la norme CPL G3. Selon ce protocole, l'émission de trames par les modems dans les conducteurs du réseau 100, est asynchrone. Un tel réseau communicant qui est conforme à la norme CPL G3 est le réseau Linky® qui est en cours de déploiement en France par ENEDIS®.

En particulier, le modem de chaque compteur de consommation électrique M ou du concentrateur C est capable d'émettre des trames de balise, en insérant dans le champ PDC (voir plus loin) de l'en-tête de chaque trame de balise la valeur instantanée du compteur de phase de ce modem. Il est rappelé que cette valeur instantanée de phase correspond au temps écoulé entre le dernier passage par la valeur nulle, sur front montant, de la tension électrique du conducteur de phase 5 auquel ce modem est connecté, et l'instant d'émission de la trame de balise. Dans la partie générale de la présente description, cette valeur du compteur de phase a été appelée indication de la valeur instantanée de phase de la tension électrique du conducteur 5 à l'émission de la trame de balise. La trame de balise est injectée dans le réseau 100 par le modem émetteur de celle-ci, à partir du conducteur de phase 5 auquel ce modem est connecté.

Pour mettre en œuvre l'invention, un opérateur mobile dans la zone géographique qui est desservie en courant électrique par le réseau 100, est muni d'un appareil portatif 10 de communication CPL compatible avec le réseau 100. Cet appareil portatif 10 peut être connecté temporairement à un endroit quelconque du réseau 100, pour communiquer avec des modems des compteurs M et du concentrateur C qui sont à portée de signal. Dans le jargon de l'Homme du métier, l'appareil 10 peut communiquer avec les modems des compteurs de consommation électrique M et du concentrateur C qui sont «visibles» à partir du point de connexion de l'appareil 10. Une telle connexion de l'appareil portatif 10 peut être effectuée via deux pointes de touche. L'une, référencée 11a, est destinée à être mise en contact avec un conducteur de phase 5, alors que l'autre, référencée 11b, est simultanément mise en contact avec un conducteur de neutre N qui est présent à proximité du conducteur de phase. L'appareil portatif 10 est aussi pourvu d'un modem 12 qui est adapté pour communiquer selon le même protocole CPL que celui du réseau 100, et pourvu d'un contrôleur 13 qui est agencé pour commander une partie au moins du fonctionnement du modem 12. Alors, conformément à la norme CPL G3, le modem 12 comprend aussi un compteur de phase à 8 bits, qui quantifie le temps écoulé depuis le dernier passage par zéro sur front montant de la tension électrique du conducteur de phase auquel l'appareil 10 est connecté.

Enfin, l'appareil portatif 10 est muni d'une sortie de données 14, qui peut être une interface homme-machine du type écran, et/ou une sortie filaire ou sans fil pour transmettre à une unité externe de traitement informatique et/ou de mémorisation, des valeurs, données et/ou résultats qui sont produits par chaque séquence mesure.

Dans la figure 1, E1 désigne l'ensemble des compteurs de consommation électrique M qui sont capables de recevoir une requête de balise émise par le modem 12 lorsque l'appareil portatif 10 est connecté au conducteur de phase CM1 du réseau 100. En outre, des trames de balise - ou balises plus simplement - qui sont émises par ces compteurs de consommation électrique M de l'ensemble E1 en réponse à la requête sont reçues correctement par le modem 12, lorsque l'appareil portatif 10 reste connecté au conducteur de phase CM1 pendant une durée de mesure suffisante. Ces compteurs de consommation électrique M de l'ensemble E1 sont dits être en visibilité directe à partir du conducteur de phase CM1. La connexion de l'appareil 10 au conducteur de phase CM1, l'émission par le modem 12 de la requête de balise, la réception par le modem 12 des balises émises par les compteurs de consommation électrique M de l'ensemble E1, puis le calcul des valeurs de déphasage et la détermination de la phase d'au moins un des conducteurs du réseau 100 constituent une séquence de mesure. Pour cette raison, le conducteur de phase CM1 a été appelé conducteur de mesure dans la partie générale de la présente description, ou premier conducteur de mesure lorsqu'il est utilisé pour une première séquence de mesure exécutée conformément au procédé de l'invention.

Après connexion de l'appareil portatif 10 au conducteur de mesure CM1, le contrôleur 13 commande une émission, par le modem 12, d'une requête de balise. Les modems des compteurs de consommation électrique M de l'ensemble E1, et du concentrateur C lorsque celui-ci est aussi dans l'ensemble E1, répondent alors en émettant en réponse à la requête, chacun une trame de balise. Chaque trame de balise qui est ainsi transmise comporte notamment les deux champs suivants dans son en-tête, conformément au protocole CPL G3 :

- un champ désigné par MAC, qui contient une adresse du modem émetteur de la trame de balise ; et

- un champ désigné par PDC, dans lequel le modem émetteur de la trame de balise inscrit la valeur instantanée de son compteur de phase, sous la forme d'un nombre à 8 bits, de 0 à 255, comme indiqué dans la partie introductive de la présente description.

Après émission de la requête de balise par le modem 12, celui-ci collecte les balises reçues en réponse, et lit dans chacune d'elles la valeur qui est inscrite dans son champ PDC. La valeur du champ PDC qui a été lue dans une balise est alors soustraite de la valeur du compteur de phase du modem 12, qui est lue à l'instant de réception de cette balise par le modem 12. Le résultat de la soustraction correspond au déphasage qui existe entre la tension électrique du conducteur CM1 et celle du conducteur 5 auquel est connecté le modem émetteur de la balise considérée. Eventuellement, ce résultat peut être corrigé d'une contribution qui correspond aux durées de traitement de la balise dans le modem émetteur pour son émission et dans le modem 12 pour la réception et la lecture de cette balise. Une telle correction est omise dans la suite par souci de clarté. Le déphasage qui est ainsi calculé peut être mémorisé au sein de l'appareil 10, ou transmis par sa sortie 14 à une unité appropriée de traitement informatique et/ou de mémorisation, notamment pour le mémoriser extérieurement par rapport à l'appareil 10.

Plus précisément, la valeur de déphasage suivante est calculée pour le modem du compteur de consommation électrique 2 (voir la figure 1), puis mémorisée en liaison avec l'adresse de ce modem :

$$\Delta\varphi_{CM1\text{-}2} = (V_{CM1} - V_2)\cdot 360/256$$

où $V_2$ est la valeur du champ PDC de la balise émise par le modem du compteur de consommation électrique 2, $V_{CM1}$ est la valeur instantanée du compteur de phase du modem 12 à l'instant de réception par celui-ci de la balise qui a été émise par le modem du compteur de consommation électrique 2, et 360/256 est un facteur de conversion entre angles de phase exprimés en degrés et valeurs de compteur de phase à 8 bits. De même, la valeur de déphasage qui est mémorisée en liaison avec l'adresse du concentrateur C est :

$$\Delta\varphi_{CM1\text{-}C} = (V_{CM1}' - V_C)\cdot 360/256$$

où $V_C$ est la valeur du champ PDC de la balise qui a été émise par le concentrateur C, et $V_{CM1}'$ est la valeur instantanée du compteur de phase du modem 12 à l'instant de réception par celui-ci de la balise qui a été émise par le concentrateur C. Par convention, la phase du conducteur 51 auquel est connecté le concentrateur C est 0°. Alors la valeur de déphasage $\Delta\varphi_{CM1\text{-}C}$ est la phase du conducteur de phase CM1, notée $\varphi_{CM1}$, modulo 360.

Avantageusement pour permettre une exploitation ultérieure des mesures, les valeurs $V_2$ et $V_{CM1}$ peuvent être mémorisées en liaison avec l'adresse du modem du compteur de consommation électrique 2, et de même les valeurs $V_C$ et $V_{CM1}'$ peuvent être mémorisées en liaison avec l'adresse du concentrateur C. L'adresse ou un identifiant du conducteur de mesure CM1 peut aussi être associé(e) à ces valeurs mémorisées.

Par combinaison des déphasages précédents, la différence suivante :

$$\Delta\varphi_{2\text{-}C} = \Delta\varphi_{CM1\text{-}C} - \Delta\varphi_{CM1\text{-}2}$$

est la phase, modulo 360, du conducteur de phase 52 auquel est connecté le modem du compteur de consommation électrique 2, notée $\varphi_2$.

La durée d'une telle séquence de mesure est de l'ordre de ou inférieure à quelques secondes, et l'exécution de cette séquence ne nécessite pas que le modem 12 soit associé au réseau CPL, ni authentifié. En effet, la norme CPL G3 spécifie que le contenu du champ PDC dans l'en-tête de chaque trame de balise ne soit pas crypté. Il est ainsi directement lisible pour le modem 12 qui n'appartient pas au réseau 100.

Une deuxième séquence de mesure peut être effectuée à partir du conducteur de phase CM2, en connectant à ce dernier l'appareil portatif 10 en remplacement du conducteur de mesure CM1. Les compteurs de consommation électrique qui sont en visibilité directe à partir du conducteur CM2 sont entourés par la boucle E2 dans la figure 1. Alors le déphasage suivant, cette fois par rapport au conducteur de mesure CM2, est calculé pour le modem du compteur de consommation électrique 2 si celui-ci est aussi en visibilité directe à partir du conducteur de mesure CM2 :

$$\Delta\varphi_{CM2\text{-}2} = (V_{CM2} - V_2')\cdot 360/256$$

où $V_2'$ est la valeur du champ PDC de la balise qui a été émise par le modem du compteur de consommation électrique 2 lors de cette deuxième séquence de mesure, et $V_{CM2}$ est la valeur du compteur de phase du modem 12 à l'instant de réception par celui-ci de la balise qui a été émise par le modem du compteur de consommation électrique 2 lors de cette deuxième séquence de mesure. De même pour le modem du compteur de consommation électrique 3 :

$$\Delta\varphi_{CM2\text{-}3} = (V_{CM2}' - V_3)\cdot 360/256$$

où $V_3$ est la valeur du champ PDC de la balise qui a été émise par le modem du compteur de consommation électrique 3 lors de cette deuxième séquence de mesure, et $V_{CM2}'$ est la valeur du compteur de phase du modem 12 à l'instant de réception par celui-ci de la balise qui a été émise par le modem du compteur de consommation électrique 3 lors de cette deuxième séquence de mesure. Alors, par différence entre les déphasages $\Delta\varphi_{CM2\text{-}2}$ et $\Delta\varphi_{CM2\text{-}3}$, il vient :

$$\Delta\varphi_{3\text{-}2} = \Delta\varphi_{CM2\text{-}2} - \Delta\varphi_{CM2\text{-}3}$$

qui est le déphasage qui existe entre le conducteur de phase auquel est connecté le modem du compteur de consommation électrique 3, référencé 53 dans la figure 1, et le conducteur de phase 52.

De même que précédemment, les valeurs $V_2'$ et $V_{CM2}$ peuvent être mémorisées en liaison avec l'adresse du modem du compteur de consommation électrique 2, et les valeurs $V_3$ et $V_{CM2}'$ peuvent être mémorisées en liaison avec l'adresse du modem du compteur de consommation électrique 3. L'adresse ou un identifiant du conducteur de mesure CM2 peut aussi être associé(e) à ces valeurs mémorisées.

En additionnant la phase $\varphi_2$ du conducteur de phase 52 qui a été obtenue lors de la première séquence de mesure, à partir du conducteur de mesure CM1, et la valeur de déphasage $\Delta\varphi_{3\text{-}2}$ qui a été obtenue lors de la deuxième séquence de mesure, à partir du conducteur de mesure CM2, il vient :

$$\Delta\varphi_{3\text{-}2} + \varphi_2 = \Delta\varphi_{3\text{-}2} + \Delta\varphi_{2\text{-}C}$$

qui est la phase $\varphi_3$ du conducteur de phase 53, modulo 360, en prenant encore comme référence de phase la phase du conducteur 51 auquel le concentrateur C est connecté.

Alternativement, le déphasage $\Delta\varphi_{3\text{-}2}$ peut avoir été obtenu d'une autre manière, par exemple par des mesures électriques telles que connues de l'art antérieur.

Lorsque plusieurs modems sont en visibilité directe à partir du conducteur de mesure CM1 et aussi à partir du conducteur de mesure CM2, la phase $\varphi_3$ du conducteur 53 peut être déterminée de façon redondante en utilisant successivement chacun de ces modems comme modem de relais, à la façon du modem du compteur de consommation électrique 2 dans ce qui vient d'être décrit. Ainsi, la phase du conducteur 53 peut être identifiée avec une fiabilité supérieure.

De la même façon, une troisième séquence de mesure peut être effectuée encore, en connectant l'appareil portatif 10 au conducteur de phase CM3. Les compteurs de consommation électrique qui sont en visibilité directe à partir du conducteur CM3 sont entourés par la boucle E3 dans la figure 1. Alors le déphasage suivant, cette fois par rapport au conducteur de mesure CM3, est calculé pour le modem du compteur de consommation électrique 3 si celui-ci est aussi en visibilité directe à partir du conducteur de mesure CM3 :

$$\Delta\varphi_{CM3\text{-}3} = (V_{CM3} - V_3')\cdot 360/256$$

où $V_3'$ est la valeur du champ PDC de la balise qui a été émise par le modem du compteur de consommation électrique 3 lors de cette troisième séquence de mesure, et $V_{CM3}$ est la valeur du compteur de phase du modem 12 à l'instant de réception par celui-ci de la balise qui a été émise par le modem du compteur de consommation électrique 3 lors de cette troisième séquence de mesure. De même pour le modem du compteur de consommation électrique 4 :

$$\Delta\varphi_{CM3\text{-}4} = (V_{CM3}' - V_4)\cdot 360/256$$

où $V_4$ est la valeur du champ PDC de la balise qui a été émise par le modem du compteur de consommation électrique 4 lors de cette troisième séquence de mesure, et $V_{CM3}'$ est la valeur du compteur de phase du modem 12 à l'instant de réception par celui-ci de la balise qui a été émise par le modem du compteur de consommation électrique 4 lors de cette troisième séquence de mesure. Alors, par différence entre les déphasages $\Delta\varphi_{CM3\text{-}3}$ et $\Delta\varphi_{CM3\text{-}4}$, il vient :

$$\Delta\varphi_{4\text{-}3} = \Delta\varphi_{CM3\text{-}3} - \Delta\varphi_{CM3\text{-}4}$$

qui est le déphasage qui existe entre le conducteur de phase auquel est connecté le modem du compteur de consommation électrique 4, référencé 54 dans la figure 1, et le conducteur de phase 53.

En additionnant la phase $\varphi_3$ du conducteur de

phase 53 qui a été obtenue à la suite de la deuxième séquence de mesure, à partir du conducteur de mesure CM2, et la valeur de déphasage $\Delta\varphi_{4\text{-}3}$ qui a été obtenue lors de la troisième séquence de mesure, à partir du conducteur de mesure CM3, il vient :

$$\Delta\varphi_{4\text{-}3} + \varphi_3 = \Delta\varphi_{4\text{-}3} + \Delta\varphi_{3\text{-}C}$$

qui est la phase $\varphi_4$ du conducteur de phase 54, modulo 360, en prenant encore comme référence de phase la phase du conducteur 51 auquel le concentrateur C est connecté.

Il est entendu que la séquence de mesure peut être répétée de nouveau, pour déterminer selon le même principe, de proche en proche, aussi dit par sauts multiples, la phase de n'importe quel conducteur de phase 5 du réseau 100. La condition pour une telle détermination est que les ensembles de modems qui sont en visibilité directe avec le conducteur de mesure utilisé à chaque séquence de mesure, aient des intersections successives non-vides de modems afin de constituer, par relais, une chaîne continue qui relie au concentrateur C chacun des conducteurs de phase dont la phase est à déterminer.

**Revendications**

1. Procédé pour déterminer une phase d'un conducteur de phase (5) appartenant à un réseau (100) polyphasé de distribution de courant électrique, notamment un réseau triphasé, dans lequel la phase d'un conducteur de phase quelconque du réseau détermine un déphasage de tension électrique qui existe entre ledit conducteur et un conducteur de phase de référence (51) du réseau,

   le réseau (100) comportant des modems qui sont connectés chacun à un des conducteurs de phase (5) dudit réseau, et qui sont adaptés pour communiquer selon un protocole de courant porteur en ligne, ou CPL,
   le procédé comprenant les étapes suivantes :

   /1/ connecter à un des conducteurs de phase du réseau (100), dit conducteur de mesure, dont la phase est à déterminer, un appareil portatif (10) qui comprend un modem (12) externe au réseau mais conforme au protocole de courant porteur en ligne dudit réseau ;
   /2/ à l'aide de l'appareil portatif (10) connecté au conducteur de mesure, injecter une requête dans le réseau (100) à partir du conducteur de mesure, pour déclencher une émission en réponse à ladite requête, de la part d'au moins un des modems du réseau, d'une trame qui contient une indication d'une valeur instantanée de phase de la tension électrique du conducteur auquel est connecté le modem émetteur de ladite trame, ladite valeur instantanée de phase de la tension électrique du conducteur auquel est connecté le modem émetteur de la trame existant à l'émission de ladite trame ;
/3/ à l'aide de l'appareil portatif (10) connecté au conducteur de mesure, collecter la trame qui a été émise par l'un au moins des modems du réseau (100) en réponse à la requête, et lire l'indication de valeur instantanée de phase qui est contenue dans ladite trame ; et
/4/ pour chaque trame reçue en réponse à la requête, déduire de l'indication de valeur instantanée de phase qui a été lue dans ladite trame, par soustraction d'une indication de la valeur instantanée de phase de la tension électrique du conducteur de mesure, telle qu'existant à un instant de réception de ladite trame par ledit appareil portatif (10), une valeur d'un déphasage qui existe entre le conducteur auquel est connecté le modem émetteur de ladite trame et le conducteur de mesure,

la valeur de déphasage déduite à l'étape /4/ indiquant la phase du conducteur de mesure lorsque le conducteur du modem émetteur de la trame est le conducteur de phase de référence (51).

2. Procédé selon la revendication 1, suivant lequel plusieurs trames sont collectées à l'étape /3/, qui ont été émises par au moins deux des modems du réseau (100) en réponse à la requête, et le procédé comprend l'étape supplémentaire suivante :
/5/ soustraire l'une à l'autre les valeurs de déphasage déduites à l'étape /4/ pour les deux conducteurs du réseau (100) auxquels sont connectés les deux modems ayant émis les trames, afin d'obtenir une valeur de déphasage desdits deux conducteurs du réseau l'un par rapport à l'autre,
la valeur de déphasage obtenue à l'étape /5/ indiquant la phase d'un des conducteurs du réseau (100) auquel est connecté l'un des deux modems qui ont émis les trames, lorsque le conducteur auquel est connecté l'autre desdits deux modems qui ont émis les trames est le conducteur de phase de référence (51).

3. Procédé selon la revendication 2, suivant lequel les étapes /1/ à /5/ sont exécutées une première fois en connectant d'abord l'appareil portatif (10) à un premier conducteur de mesure (CM1) appartenant au réseau (100), pour obtenir lors d'une première exécution de l'étape /5/, dite étape /5-1/, une valeur de déphasage qui existe entre un premier conducteur de phase du réseau et un deuxième conducteur de phase du réseau, lesdits premier et deuxième conducteurs de phase étant différents du premier conducteur de mesure,

puis les étapes /1/ à /5/ sont exécutées une seconde fois en connectant l'appareil portatif (10) à un second conducteur de mesure (CM2) appartenant au réseau (100), différent du premier conducteur de mesure (CM1), pour obtenir lors d'une seconde exécution de l'étape /5/, dite étape /5-2/, une autre valeur de déphasage qui existe entre le deuxième conducteur de phase du réseau et un troisième conducteur de phase du réseau, lesdits deuxième et troisième conducteurs de phase étant différents du second conducteur de mesure,

et le procédé comprend en outre, lors d'une étape /6/, de combiner l'une avec l'autre les valeurs de déphasage obtenues aux étapes /5-1/ et /5-2/, pour obtenir une valeur de déphasage qui existe entre les premier et troisième conducteurs de phase du réseau (100),

la valeur de déphasage obtenue à l'étape /6/ indiquant la phase du troisième conducteur de phase lorsque le premier conducteur de phase est le conducteur de phase de référence (51).

4. Procédé selon la revendication 3, suivant lequel la valeur de déphasage obtenue à l'étape /6/ entre les premier et troisième conducteurs de phase du réseau (100), est combinée lors d'une étape /7/ avec une valeur de déphasage qui existe entre le troisième conducteur de phase du réseau et un quatrième conducteur de phase du réseau, pour obtenir une valeur de déphasage qui existe entre les premier et quatrième conducteurs de phase du réseau,

la valeur de déphasage obtenue à l'étape /7/ indiquant la phase du quatrième conducteur de phase lorsque le premier conducteur de phase est le conducteur de phase de référence (51).

5. Procédé selon l'une quelconque des revendications 2 à 4, suivant lequel un des modems émetteur d'une trame qui a été collectée lors d'une exécution de l'étape /3/, est une partie d'un concentrateur (C) du réseau (100).

6. Procédé selon l'une quelconque des revendications précédentes, suivant lequel la requête qui est injectée dans le réseau (100) par l'appareil portatif (10) à l'étape /2/ est une requête de balise, et chaque trame qui est collectée à l'étape /3/ est une trame de balise qui contient l'indication de la valeur instantanée de phase de la tension électrique du conducteur auquel est connecté le modem émetteur de ladite trame de balise, telle que ladite valeur instantanée de phase existe à l'émission de ladite trame de balise.

7. Procédé selon l'une quelconque des revendications précédentes, suivant lequel l'appareil portatif (10) comprend deux connecteurs (11a, 11b) chacun adapté pour établir un contact électrique avec un conducteur du réseau (100), et ledit appareil portatif est connecté à l'étape /1/ entre le conducteur de mesure d'une part, et d'autre part un conducteur de neutre (N) du réseau (100) ou un conducteur de terre dudit réseau.

8. Procédé selon l'une quelconque des revendications précédentes, suivant lequel les phases déterminées pour plusieurs conducteurs (5) du réseau (100), lorsque lesdites phases sont différentes, sont utilisées pour équilibrer entre lesdits plusieurs conducteurs une puissance électrique qui est fournie par le réseau.

9. Appareil portatif (10) comprenant :

- deux connecteurs (11a, 11b), l'un adapté pour établir un contact électrique avec un conducteur de phase (5) d'un réseau (100) polyphasé de distribution de courant électrique, et l'autre adapté pour établir un autre contact électrique avec un conducteur de neutre (N) ou un conducteur de terre dudit réseau ;
- un modem (12), raccordé aux deux connecteurs (11a, 11b) et adapté pour communiquer selon un protocole de courant porteur en ligne, ou CPL ;
- un contrôleur (13), agencé pour commander au modem (12) d'émettre une requête de trame par les deux connecteurs (11a, 11b) ; et
- une sortie (14), agencée pour transmettre l'une au moins des valeurs suivantes :

une valeur de déphasage qui existe entre deux conducteurs de phase (5) du réseau (100), calculée par l'appareil portatif (10), une indication d'une valeur instantanée de phase qui est lue dans une trame reçue par le modem (12) par l'intermédiaire des deux connecteurs (11a, 11b), et

une indication d'une autre valeur instantanée de phase, qui est fournie par le modem (12) de l'appareil portatif (10) lorsqu'une trame est reçue par ledit modem, ladite autre valeur instantanée de phase étant relative à une tension électrique d'un conducteur de phase (5) du réseau (100) avec lequel l'un des deux connecteurs (11a, 11b) est en contact électrique,

l'appareil étant adapté pour exécuter les étapes /1/ à /4/ d'un procédé conforme à l'une quelconque des revendications précédentes.

**Patentansprüche**

1. Verfahren zur Bestimmung einer Phase eines Phasenleiters (5), der zu einem mehrphasigen Netz (100) zur Verteilung von elektrischem Strom gehört, insbesondere einem Dreiphasen-Netz, wobei die Phase eines beliebigen Phasenleiters (5) des Netzes eine elektrische Spannungsphasenverschiebung bestimmt, die zwischen dem Leiter und einem Referenzphasenleiter (51) des Netzes besteht,

wobei das Netz (100) Modems umfasst, die jeweils mit einem der Phasenleiter (5) des Netzes verbunden sind und die derart ausgebildet sind, dass sie gemäß einem Powerline-Protokoll (PLC) kommunizieren können, wobei das Verfahren die folgenden Schritte umfasst:

/1/ Verbinden eines tragbaren Geräts (10) mit einem der Phasenleiter des Netzes (100), dem sogenannten Messleiter, dessen Phase zu bestimmen ist, wobei das tragbare Gerät ein Modem (12) außerhalb des Netzes umfasst, das aber mit dem Powerline-Protokoll des Netzes kompatibel ist;
/2/ mit Hilfe des tragbaren Geräts (10), das mit dem Messleiter verbunden ist, Einspeisen einer Anfrage vom Messleiter aus in das Netz (100), um als Antwort auf diese Anfrage eine Übertragung von wenigstens einem der Modems des Netzes auszulösen, eines Frames, der eine Angabe eines momentanen Phasenwerts der elektrischen Spannung des Leiters umfasst, mit dem das den Frame sendende Modem verbunden ist, wobei der momentane Phasenwert der elektrischen Spannung des Leiters, mit dem das den Frame sendende Modem verbunden ist, bei der Übertragung des Frames vorhanden ist;
/3/ Erfassen des Frames, der von wenigstens einem der Modems des Netzes (100) als Antwort auf die Anfrage gesendet wurde, und Lesen der in dem Frame enthaltenen Angabe des momentanen Phasenwerts mit Hilfe des mit dem Messleiter verbundenen tragbaren Geräts (10); und
/4/ für jeden Frame, der als Antwort auf die Anfrage erfasst wird, Ableiten eines Wertes einer Phasenverschiebung, die zwischen dem Leiter, mit dem das Modem, das den Frame sendet, verbunden ist, und dem Messleiter besteht, von der Angabe des momentanen Phasenwertes, der in dem Frame gelesen wurde, durch Subtraktion einer Angabe des momentanen Phasenwertes der elektrischen Spannung des Messleiters, wie er zu einem Zeitpunkt des Empfangs des Frame durch das tragbare Gerät (10) existiert,
wobei der in Schritt /4/ abgeleitete Wert der Phasenverschiebung die Phase des Messleiters angibt, wenn der Leiter des Modems, das den Frame sendet, der Referenzphasenleiter (51) ist.

2. Verfahren nach Anspruch 1, wobei in Schritt /3/ mehrere Frames erfasst werden, die von wenigstens zwei der Modems des Netzes (100) als Antwort auf die Anfrage gesendet wurden, und wobei das Verfahren den folgenden zusätzlichen Schritt umfasst:
/5/ Subtrahieren der in Schritt /4/ abgeleiteten Phasenverschiebungswerte für die beiden Leiter des Netzes (100), mit denen die beiden Modems, die die Frames gesendet haben, verbunden sind, voneinander, um einen Phasenverschiebungswert der beiden Leiter des Netzes in Bezug zueinander zu erhalten,
wobei der in Schritt /5/ erhaltene Phasenverschiebungswert die Phase eines der Leiter des Netzes (100) angibt, mit dem eines der beiden Modems, die die Frames gesendet haben, verbunden ist, wenn der Leiter, mit dem das andere der beiden Modems, die die Frames gesendet haben, verbunden ist, der Referenzphasenleiter (51) ist.

3. Verfahren nach Anspruch 2, wobei die Schritte /1/ bis /5/ ein erstes Mal ausgeführt werden, indem das tragbare Gerät (10) zuerst mit einem ersten Messleiter (CM1) verbunden wird, der zum Netz (100) gehört, um bei einer ersten Ausführung von Schritt /5/, Schritt /5-1 / genannt, einen Wert der Phasenverschiebung zu erhalten, der zwischen einem ersten Phasenleiter des Netzes und einem zweiten Phasenleiter des Netzes besteht, wobei sich der erste und der zweite Phasenleiter von dem ersten Messleiter unterscheiden,

wobei dann die Schritte /1/ bis /5/ ein zweites Mal ausgeführt werden, indem das tragbare Gerät (10) mit einem zweiten Messleiter (CM2) verbunden wird, der zum Netz (100) gehört und sich vom ersten Messleiter (CM1) unterscheidet, um bei einer zweiten Ausführung des Schritts /5/, Schritt /5-2/ genannt, einen anderen Wert der Phasenverschiebung zu erhalten, der zwischen dem zweiten Phasenleiter des Netzes und einem dritten Phasenleiter des Netzes besteht, wobei sich der zweite und der dritte Phasenleiter vom zweiten Messleiter unterscheiden,

und das Verfahren ferner in einem Schritt /6/ das Kombinieren der in den Schritten /5-1/ und /5-2/ erhaltenen Phasenverschiebungswerte miteinander umfasst, um einen Phasenverschiebungswert zu erhalten, der zwischen dem ersten und dem dritten Phasenleiter des Netzes (100) besteht,

wobei der in Schritt /6/ erhaltene Phasenverschiebungswert die Phase des dritten Phasenleiters angibt, wenn der erste Phasenleiter der Referenzphasenleiter (51) ist.

4. Verfahren nach Anspruch 3, wobei der in Schritt /6/ erhaltene Phasenverschiebungswert zwischen dem ersten und dem dritten Phasenleiter des Netzes (100) in Schritt /7/ mit einem Phasenverschiebungswert kombiniert wird, der zwischen dem dritten Phasenleiter des Netzes und einem vierten Phasenleiter des Netzes besteht, um einen Phasenverschiebungswert zu erhalten, der zwischen dem ersten und dem vierten Phasenleiter des Netzes besteht,

wobei der in Schritt /7/ erhaltene Phasenverschiebungswert die Phase des vierten Phasenleiters angibt, wenn der erste Phasenleiter der Referenzphasenleiter (51) ist.

5. Verfahren nach einem der Ansprüche 2 bis 4, wobei eines der Modems, die einen Frame senden, der bei der Durchführung von Schritt /3/ erfasst wurde, Teil eines Konzentrators (C) des Netzes (100) ist.

6. Verfahren nach einem der vorhergehenden Ansprüche, wobei die Anfrage, die in Schritt /2/ von dem tragbaren Gerät (10) in das Netz (100) eingespeist wird, eine Beacon-Anfrage ist, und jeder Frame, der in Schritt /3/ erfasst wird, ein Beacon-Frame ist, der die Angabe des momentanen Phasenwertes der elektrischen Spannung des Leiters enthält, mit dem das Modem verbunden ist, das den Beacon-Frame sendet, so dass der momentane Phasenwert bei der Übertragung des Beacon Frames existiert.

7. Verfahren nach einem der vorhergehenden Ansprüche, wobei das tragbare Gerät (10) zwei Verbindungselemente (11a, 11b) umfasst, die jeweils dazu ausgebildet sind, einen elektrischen Kontakt mit einem Leiter des Netzes (100) herzustellen, und wobei das tragbare Gerät in Schritt /1/ zwischen dem Messleiter einerseits und einem Neutralleiter (N) des Netzes (100) oder einem Erdungsleiter des Netzes andererseits verbunden wird.

8. Verfahren nach einem der vorhergehenden Ansprüche, wobei die für mehrere Leiter (5) des Netzes (100) ermittelten Phasen, wenn diese Phasen unterschiedlich sind, dazu verwendet werden, eine vom Netz gelieferte elektrische Leistung zwischen den mehreren Leitern auszugleichen.

9. Tragbare Vorrichtung (10), welche Folgendes umfasst:

- zwei Verbindungselemente (11a, 11b), von denen eines zur Herstellung eines elektrischen Kontakts mit einem Phasenleiter (5) eines mehrphasigen Stromverteilungsnetzes (100) und der andere zur Herstellung eines weiteren elektrischen Kontakts mit einem Neutralleiter (N) oder einem Erdungsleiter des Netzes ausgebildet ist;
- ein Modem (12), das mit den beiden Verbindungselementen (11a, 11b) verbunden ist und zur Kommunikation gemäß einem PLC-Protokoll (Powerline Communication) ausgebildet ist;
- einen Controller (13), der dazu angeordnet ist, dem Modem (12) zu befehlen, eine Frameanfrage über die beiden Verbindungselemente (11a, 11b) zu senden; und
- einen Ausgang (14), der dazu angeordnet ist, wenigstens einen der folgenden Werte zu übertragen:
- einen Wert der Phasenverschiebung, die zwischen zwei Phasenleitern (5) des Netzes (100) besteht und von dem tragbaren Gerät (10) berechnet wird,
- eine Angabe eines momentanen Phasenwertes, der in einem vom Modem (12) über die beiden Verbindungselemente (11a, 11b) erfassten Frames gelesen wird, und
- eine Angabe eines weiteren momentanen Phasenwertes, der von dem Modem (12) des tragbaren Geräts (10) geliefert wird, wenn ein Frame von dem Modem erfasst wird, wobei sich der weitere momentane Phasenwert auf eine elektrische Spannung eines Phasenleiters (5) des Netzes (100) bezieht, mit dem eines der beiden Verbindungselemente (11a, 11b) in elektrischem Kontakt steht,

wobei die Vorrichtung dazu ausgebildet ist, die Schritte /1/ bis /4/ eines Verfahrens nach einem der vorhergehenden Ansprüche auszuführen.

## Claims

1. A method for determining a phase of a phase conductor (5) belonging to a polyphase electric power distribution grid (100), in particular a three-phase grid, wherein the phase of any phase conductor of the grid determines an electrical voltage phase shift that exists between said conductor and a reference phase conductor (51) of the grid,

the grid (100) including modems which are each connected to one of the phase conductors (5) of said grid, and which are adapted to communicate according to a power line carrier protocol, or PLC,

the method comprising the following steps:

/1/ connecting to one of the phase conductors of the grid (100), referred to as the measurement conductor, the phase of which is to be determined, a portable device (10) which includes a modem (12) external to the grid but conforming to the power line carrier protocol of said grid;

/2/ using the portable device (10) connected to the measurement conductor, injecting a request into the grid (100) from the measurement conductor to trigger a transmission, in response to said request, by at least one of the modems of the grid, of a frame which contains an indication of an instantaneous value of the phase of the electrical voltage of the conductor to which is connected the modem transmitting said frame, said instantaneous value of the phase of the electrical voltage of the conductor to which is connected the modem transmitting the frame existing at the time of transmission of said frame;

/3/ using the portable device (10) connected to the measurement conductor, collecting the frame that has been transmitted by at least one of the modems of the grid (100) in response to the request and reading the instantaneous phase value indication that is contained in said frame; and

/4/ for each frame received in response to the request, deriving from the instantaneous phase value indication that has been read in said frame, by subtracting an indication of the instantaneous phase value of the electric voltage of the measurement conductor, as existing at a time of receiving said frame by said portable device (10), a phase shift value that exists between the conductor to which is connected the modem transmitting said frame and the measurement conductor,

the phase shift value derived in step /4/ indicating the phase of the measurement conductor when the conductor of the modem transmitting the frame is the reference phase conductor (51).

2. The method according to claim 1, wherein a plurality of frames are collected in step /3/, which have been transmitted by at least two modems of the grid (100) in response to the request, and the method comprises the following additional step:

/5/ subtracting from each other the phase shift values derived in step /4/ for the two conductors of the grid (100) to which are connected the two modems that have transmitted the frames, in order to obtain a phase shift value of said two conductors of the grid with respect to one another,

the phase shift value obtained in step /5/ indicating the phase of one of the grid conductors (100) to which is connected one of the two modems that have transmitted the frames, when the conductor to which is connected the other one of said two modems that have transmitted the frames is the reference phase conductor (51).

3. The method according to claim 2, wherein steps /1/ to /5/ are executed a first time by firstly connecting the portable device (10) to a first measurement conductor (CM1) belonging to the grid (100), to obtain in a first execution of step /5/, referred to as step /5-1/, a phase shift value which exists between a first phase conductor of the grid and a second phase conductor of the grid, said first and second phase conductors being different from the first measurement conductor,

then steps /1/ to /5/ are executed a second time by connecting the portable device (10) to a second measurement conductor (CM2) belonging to the grid (100), different from the first measurement conductor (CM1), to obtain in a second execution of step /5/, referred to as step /5-2/, another phase shift value that exists between the second phase conductor of the grid and a third phase conductor of the grid, said second and third phase conductors being different from the second measurement conductor,

and the method further comprises, in step /6/, combining with each other the phase shift values obtained in steps /5-1/ and /5-2/, to obtain a phase shift value that exists between the first and third phase conductors of the grid (100),

the phase shift value obtained in step /6/ indicating the phase of the third phase conductor when the first phase conductor is the reference phase conductor (51).

4. The method according to claim 3, wherein the phase shift value obtained in step /6/ between the first and third phase conductors of the grid (100), is combined in step /7/ with a phase shift value that exists between the third phase conductor of the grid and a fourth phase conductor of the grid, to obtain a phase shift value that exists between the first and fourth phase conductors of the grid,

the phase shift value obtained in step /7/ indicating the phase of the fourth phase conductor when the first phase conductor is the reference phase conductor (51).

**5.** The method according to any one of claims 2 to 4, wherein one of the modems transmitting a frame that was collected during an execution of step /3/ is part of a hub (C) of the grid (100).

**6.** The method according to any one of the preceding claims, wherein the request that is injected into the grid (100) by the portable device (10) in step /2/ is a beacon request, and each frame that is collected in step /3/ is a beacon frame that contains the indication of the instantaneous phase value of the electrical voltage of the conductor to which is connected the modem transmitting said beacon frame, such that said instantaneous phase value exists at the time of transmission of said beacon frame.

**7.** The method according to any one of the preceding claims, wherein the portable device (10) comprises two connectors (11a, 11b) each adapted to establish an electrical contact with a conductor of the grid (100), and said portable device is connected in step /1/ between the measurement conductor on the one hand and on the other hand a neutral conductor (N) of the grid (100) or a grounded conductor of said grid.

**8.** The method according to any one of the preceding claims, wherein the phases determined for a plurality of conductors (5) of the grid (100), when said phases are different, are used to balance between said plurality of conductors an electric power which is supplied by the grid.

**9.** A portable device (10) comprising:

- two connectors (11a, 11b), one of them adapted to make electrical contact with a phase conductor (5) of a polyphase electrical power distribution grid (100), and the other one adapted to establish another electrical contact with a neutral conductor (N) or a grounded conductor of said grid;
- a modem (12), connected to both connectors (11a, 11b) and adapted to communicate according to a power line carrier protocol, or PLC;
- a controller (13), arranged to control the modem (12) to transmit a frame request through both connectors (11a, 11b); and
- an output (14), arranged to transmit to at least one of the following values:

a phase shift value that exists between two phase conductors (5) of the grid (100), calculated by the portable device (10), an indication of an instantaneous phase value that is read in a frame received by the modem (12) through both connectors (11a, 11b), and an indication of another instantaneous phase value, which is provided by the modem (12) of the portable apparatus (10) when a frame is received by said modem, said another instantaneous phase value pertaining to an electrical voltage of a phase conductor (5) of the grid (100) with which one of both connectors (11a, 11b) is in electrical contact,

the device being adapted to execute steps /1/ to /4/ of a method according to any one of the preceding claims.

**FIG. 1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2005116668 A1
- US 2015091545 A1